# EUROPEAN PATENT SPECIFICATION

(11) **EP 0 670 595 B1**
(45) Date of publication and mention of the grant of the patent: **27.05.1998**
(21) Application number: 95101626.0
(22) Date of filing: 07.02.1995
(51) Int. Cl.: H01L 23/31, H01L 23/29

(54) **Resin-sealed semiconductor device**
Mit Harz eingekapseltes Halbleiterbauelement
Dispositif à semi-conducteur encapsulé par de la résine

(30) Priority: 08.02.1994 JP 35426/94
(43) Date of publication of application: 06.09.1995
(73) Proprietor: Dow Corning Toray Silicone Company, Limited, Tokyo 103 (JP)
(72) Inventor: Kasuya, Akira, Dow Corning Toray Silicone Co., Ltd, Ichihara-shi, Chiba Pref. (JP); Mine, Katsutoshi, Dow Corning Toray Silicone, Ichihara-shi, Chiba Pref. (JP); Yamakawa, Kimio, Dow Corning Toray Silicone, Ichihara-shi, Chiba Pref. (JP)
(74) Representative: Spott, Gottfried, Dr.

(56) References cited:
- EP-A- 0 470 559
- PATENT ABSTRACTS OF JAPAN vol. 011 no. 346 (E-556) 12 November 1987 & JP-A-62 125 653 (MITSUBISHI ELECTRIC CORP) 6 June 1987
- PATENT ABSTRACTS OF JAPAN vol. 016 no. 240 (E-1211) 3 June 1992 & JP-A-04 048 758 (TORAY DOW CORNING SILICONE CO LTD) 18 February 1992
- PATENT ABSTRACTS OF JAPAN vol. 004 no. 130 (E-025) 12 September 1980 & JP-A-55 082 455 (TOSHIBA CORP) 21 June 1980
- PATENT ABSTRACTS OF JAPAN vol. 012 no. 099 (E-594) 31 March 1988 & JP-A-62 229 862 (IBIDEN CO LTD) 8 October 1987
- PATENT ABSTRACTS OF JAPAN vol. 009 no. 220 (E-341) 6 September 1985 & JP-A-60 080 258 (FUJI XEROX KK) 8 May 1985

## Description

The invention relates to a resin-sealed semiconductor device that exhibits high reliability in heat-cycle and impact-resistance testing.

Resin-sealed semiconductor devices can be sealed by forming a cured resin dam around the periphery of a semiconductor element residing on the surface of a circuit board and by then covering the semiconductor element mounted within the cured resin dam with a cured resin sealant. This type of resin-sealed semiconductor device has several distinctive features. The semiconductor element is protected from external impact and moisture, while only the specific semiconductor element is coated with cured resin sealant.

Various proposals have been made in this regard in the prior art. For example, Japanese Patent Publication (Kokai) 62-229862 (229,862/1987) teaches a resin-sealed semiconductor device in which a cured resin dam, obtained by the cure of a heat-curable resin filled with water-repellent filler, is formed around the periphery of a semiconductor element residing on a circuit board. The semiconductor element in this document is mounted within the cured resin dam and is covered with a cured resin sealant. This publication describes a resin-sealed semiconductor device in which a cured resin dam, obtained by the cure of a thixotropic curable resin composition, is formed around the periphery of the semiconductor element residing on a circuit board. The semiconductor element mounted within the cured resin dam is then covered with a cured resin sealant. Japanese Patent Publication (Kokai) 4-48758 (48,758/1992) proposes a resin-sealed semiconductor device in which a cured resin dam with a JIS A hardness of 5 to 64 as defined in JIS K-6301 is formed around the periphery of the semiconductor element mounting region on the surface of a circuit board. The semiconductor element mounted within the cured resin dam is covered by a cured resin sealant that has a JIS A hardness of 65 to 95.

However, the resin-sealed semiconductor device of Japanese Publication 62-229862, however, suffers from poor adhesion between the cured resin dam and the cured resin sealant, and as a result exhibits a low reliability in high temperature/high humidity ambients. It also employs a very hard cured resin sealant to protect the semiconductor element from external impact during impact-resistance testing. High internal stresses can occur in the cured resin sealant as a consequence. During heat-cycle testing the bonding wires that electrically connect the semiconductor element and the interconnect conductors may also be deformed or broken.

In contrast, the resin-sealed semiconductor device proposed in Japanese Patent Publication 4-48758 exhibits excellent reliability in heat-cycle testing. In this particular device, the cured resin dam formed around the semiconductor element mounting region on the circuit board very closely abuts the bonding wires that electrically connect the semiconductor element to the circuit board. The semiconductor element mounted within the cured resin dam is again covered with a cured resin sealant.

The trend over the last several years has been to use ever smaller amounts of cured resin in resin-sealed semiconductor devices. This has led to an examination of these devices in which the cured resin dam is formed in the zone of the bonding wires that connect the device to the circuit board. However, these resin-sealed semiconductor devices continue to suffer from poor reliability during heat-cycle or impact-resistance testing because the bonding wires frequently undergo deformation or rupture.

The present invention is the result of extensive investigations directed at solving the above problems. Specifically, our invention takes as its object the introduction of a resin-sealed semiconductor device that exhibits high reliability in heat-cycle and impact-resistance testing. A device according to the preamble of claim 1 is known from JP-A-62 125 653.

Our resin-sealed semiconductor device comprises a resin-sealed semiconductor device wherein a cured resin dam with a JIS A hardness of 40 to 95 is formed in the zone of the bonding wires that electrically connect the semiconductor element onto the surface of a circuit board. The semiconductor element is then mounted within the cured resin dam, and it is covered with a cured resin sealant having a JIS A hardness of 1 to 39.

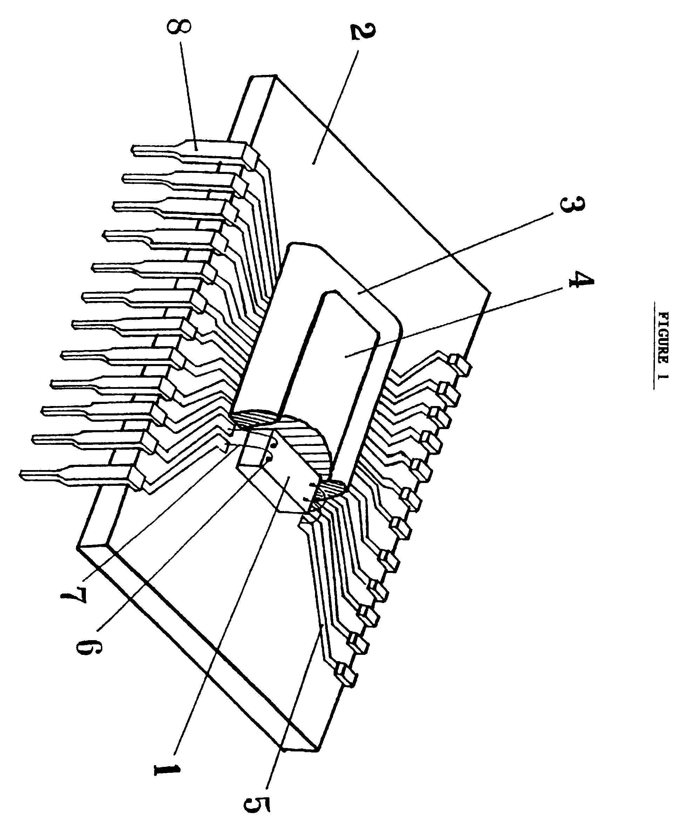

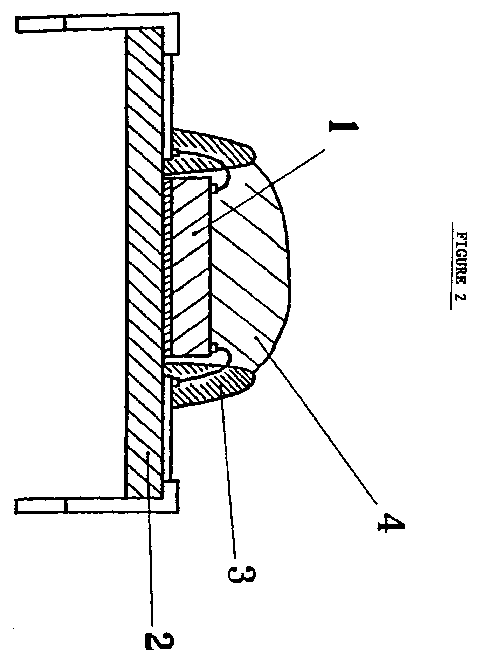

Figure 1 contains a partially cut-away oblique view of a resin-sealed semiconductor device of this invention. Figure 2 contains a cross section of the device depicted in Figure 1.

The resin-sealed semiconductor device of our invention will be explained with reference to the drawings contained in Figures 1 and 2.

In our resin-sealed semiconductor device, a semiconductor element **1** is mounted on the surface of a circuit board **2**, and bonding wires **7** electrically connect the semiconductor element **1** to conductors **5** formed on the circuit board **2**. In addition, a cured resin dam **3** is formed in the bonding wire **7** zone, and the semiconductor element **1**, which is mounted within said cured resin dam **3**, is coated with a cured resin sealant **4**. The material making up the circuit board **2** is exemplified by organic resins such as glass/epoxy resin, bakelite resin, paper/bakelite resin, phenolic resins, and paper/phenolic resin; by ceramics such as glass, or alumina; and by metals such as copper, or aluminum. The conductors **5** are formed on one or both surfaces of circuit board **2** and are composed of conductive material such as copper, or silver-palladium. The semiconductor element **1** is mounted on the circuit board **2**, and the bonding wires **7**, which consist of thin conductive wires of gold, copper, or aluminum, provide electrical connection between the conductors **5** and the bonding pads **6** present at the edge of the semiconductor element **1**. The conductors **5** are in turn electrically connected to outer lead terminals **8** which are placed on at least one edge of the circuit board **2**. Our resin-sealed semiconductor device includes devices generally known as hybrid ICs, in which other electronic components, such as resistors, condensers, and coils, are also mounted on the circuit board **2**.

The cured resin dam **3**, which is formed in the zone of the bonding wires **7** that electrically connect the semiconductor element **1** on the circuit board **2** to the conductors **5**, is required in our semiconductor device to have a JIS A hardness, measured according to JIS K-6301, of 40 to 95. A cured resin dam **3** with a JIS A hardness below 40 cannot protect the semiconductor element **1** because resin dam **3** will be easily deformed in impact-resistance testing by external forces from the side. When the cured resin dam **3** has a JIS A hardness in excess of 95, the dam will be brittle and prone to cracking when subjected to external forces. The cured resin dam **3** of our the resin-sealed semiconductor device preferably has a tear strength of at least 2.0 kg_{f}/cm as measured on the type A test specimen described in JIS K-6301.

The cured resin sealant **4**, which covers the semiconductor element **1** mounted within the cured resin dam **3**, is required in our semiconductor device to have a JIS A hardness, measured according to JIS K-6301, of 1 to 39. A cured resin sealant **4** with a JIS A hardness below 1 cannot protect the semiconductor device **1** from external forces because resin sealant **4** can be deformed by impact in impact-resistance testing. The internal stresses are increased in a cured resin sealant **4** with a JIS A hardness in excess of 39 to such a degree that the corresponding semiconductor device exhibits a substantially diminished reliability when subjected to heat-cycle testing.

The cured resin dam **3** and the cured resin sealant **4** in our resin-sealed semiconductor device can be prepared from curable epoxy resin compositions, curable silicone compositions, curable polyimide resin compositions, and curable polyester resin compositions. Either or both of the cured resin dam **3** and the cured resin sealant **4** are preferably fabricated from a curable silicone composition. Curable silicone compositions suitable for fabrication of our resin-sealed semiconductor device are exemplified by addition reaction-curing silicone compositions, condensation reaction-curing silicone compositions, and organoperoxide-curing silicone compositions. A condensation reaction-curing silicone composition is preferably used when the semiconductor element **1** must be sealed without applying heat. Otherwise, the use of addition reaction-curing silicone compositions is preferred because this supports a highly productive fabrication rate of our resin-sealed semiconductor devices.

Our resin-sealed semiconductor device is explained in greater detail through working examples. The viscosity values reported in the examples were measured at 25°C. The JIS A hardness of the cured resin dam and the cured resin sealant was measured using the type A hardness meter described in JIS K-6301 after the particular resin composition had been cured at 150°C for 1 hour.

Example 1. Resin-sealed semiconductor devices were fabricated by the following process:
1) A semiconductor device **1** carrying bonding pads **6** on its edges was mounted on the surface of a circuit board **2**. This circuit board **2** carried silver-palladium conductors **5** and was equipped with outer lead terminals **8** running from the terminals of the silver-palladium conductors **5**.
(2) The bonding pads **6** on the semiconductor element **1** mounted on the circuit board **2** were then connected by gold bonding wires **7** to the silver-palladium conductors **5**.
(3) Using a dispenser, an addition reaction-curing silicone rubber composition (I) (viscosity = 100 Pa.s (1,000 poise), JIS A hardness of the cured silicone rubber product = 70) was then applied in the shape of a dam in the zone of the gold bonding wires **7** on the circuit board **2**.
(4) Again using a dispenser, the semiconductor element **1** mounted within the dam of addition reaction-curing silicone rubber composition (I) was completely covered with an addition reaction-curing silicone rubber composition (II). This addition reaction-curing silicone rubber composition (II) had a viscosity of 2 Pa.s (20 poise), and when cured was transparent and had a JIS A hardness of 20.
(5) The resin-sealed semiconductor device was produced by holding the circuit board prepared above in a forced convection oven for 1 hour at 150°C to cure addition reaction-curing silicone rubber compositions (I) and (II). Fifty resin-sealed semiconductor devices were fabricated by this procedure.

Twenty-five of the resin-sealed semiconductor devices were subjected to 100 cycles of heat-cycle testing (1 cycle = residence for 30 minutes at -30°C followed by residence for 30 minutes at 120°C). After completion of the test, electrical conduction integrity testing was carried out on the semiconductor element **1** and the gold bonding wires **7** using the outer lead terminals **8** of the resin-sealed semiconductor device. The results of this testing showed a complete absence of conduction faults. In addition, cracks were not produced in either the cured resin dam or the cured resin sealant.

Twenty-five of the resin-sealed semiconductor devices were also subjected to drop testing, in which each device was allowed to freely fall onto a flat iron surface from a height of 1 m. After completion of the test, conduction integrity testing was again performed. The results showed a complete absence of conduction faults. In addition, cracks were not produced in either the cured resin dam or the cured resin sealant. Inspection through the transparent cured resin sealant using an optical microscope confirmed that no deformation or breakage of the gold bonding wires **7** had occurred at any gold bonding wire **7**/bonding pad **6** connection region or at gold bonding wire **7**/silver-palladium conductor **5** connection region.

Comparative Example 1. Fifty resin-sealed semiconductor devices were fabricated using the procedure described in Example 1, but in this case using an addition reaction-curing silicone rubber composition (III) in place of the composition (I) of Example 1. This addition reaction-curing silicone rubber composition (III) had a viscosity of 150 Pa.s (1,500 poise), and when cured had a JIS A hardness of 20.

Twenty-five of these resin-sealed devices were subjected to heat-cycle testing as in Example 1. No conduction faults were found in any of the resin-sealed semicondutor devices. Twenty-five of the resin-sealed devices were also subjected to drop testing as in Example 1. In this case, conduction faults were produced in 5 of the resin-sealed semiconductor devices. The devices having conduction faults were inspected through the transparent cured resin sealant using an optical microscope. In each of these defective devices, deformation or breakage of gold bonding wires **7** was found at either the gold bonding wire **7**/bonding pad **6** connection region or at the gold bonding wire **7**/silver-palladium conductor **5** connection region.

Comparative Example 2. Fifty resin-sealed semiconductor devices were fabricated using the procedure of Example 1, but in this case using an addition reaction-curing silicone gel composition (IV) in place of the composition (II). Curing of the addition reaction-curing silicone gel composition (IV) gave a silicone gel with a JIS A hardness of 0.

Twenty-five of these devices were subjected to heat-cycle testing as in Example 1. No conduction faults were found in any of the devices. Twenty-five of these devices were also subjected to drop testing as in Example 1. In three of the resin-sealed semiconductor devices, the silicone gel had flowed over and beyond the cured dam to produce a defective appearance.

Example 2. Fifty resin-sealed semiconductor devices were fabricated using a nonfluid, alcohol-liberating condensation reaction-curing silicone rubber composition (V) in place of the composition (I), of Example 1, and using an addition reaction-curing silicone rubber composition (VI) in place of the composition (II). Curing of silicone rubber composition (V) gave a silicone rubber with a JIS A hardness of 42. Silicone rubber composition (VI) had a viscosity of 3.5 Pa.s (35 poise), and its cure gave a silicone rubber with a JIS A hardness of 36. The curing phase consisted of residence for 1 hour in a forced convection oven at 150°C followed by residence for 3 days at 25°C and 50% relative humidity.

Twenty-five of these devices were subjected to heat-cycle testing as in Example 1. No conduction faults were found in any of the devices. Twenty-five of these devices were also subjected to drop testing as in Example 1. The results from drop testing were a complete absence of conduction faults, a complete absence of cracking in the cured resins, and a complete absence of deformation or breakage in the gold bonding wires.

Comparative Example 3. Fifty resin-sealed semiconductor devices were fabricated according to the procedure of Example 1, but using an addition reaction-curing silicone rubber composition (VII) in place of composition (I), and using an addition reaction-curing silicone rubber composition (VIII) in place of composition (II). Silicone rubber composition (VII) had a viscosity of 100 Pa.s (1,000 poise), and when cured had a JIS A hardness of 10. Silicone rubber composition (VIII) had a viscosity of 2.5 Pa.s (25 poise), and when cured had a JIS A hardness of 70.

Twenty-five of these devices were subjected to heat-cycle testing as in Example 1. No conduction faults were found in any of the devices. Twenty-five of the devices were also subjected to drop testing as in Example 1. While drop testing did not produce conduction faults or cracks in the cured resins, drop testing did produce deformation of the gold bonding wires in 2 of the semiconductor devices.

## Claims

1. A resin-sealed semiconductor device in which a cured resin dam is formed in the zone of the bonding wires that electrically connect a semiconductor element onto the surface of a circuit board and the semiconductor element is mounted within the cured resin dam and is covered with a cured resin sealant, whereby the cured resin dam has a higher hardness than the cured resin sealant, characterized in that the cured resin dam has a JIS A hardness of 40 to 95 and the cured resin sealant has a JIS A hardness of 1 to 39.

2. A resin-sealed device according to Claim 1, where the cured resin dam and the cured resin sealant comprise an addition reaction-curing composition.

## Patentansprüche

1. Harz-vergossene Halbleitervorrichtung, in der ein Damm aus gehärtetem Harz in der Zone der Kontaktierdrähte ausgebildet ist, die ein Halbleiterelement auf der Oberfläche einer Schaltungskarte elektrisch anschließen, und das Halbleiterelement innerhalb des Damms aus gehärtetem Harz montiert und mit einer Vergußmasse aus gehärtetem Harz bedeckt ist und der Damm aus gehärtetem Harz eine größere Härte als die Vergußmasse aus gehärtetem Harz hat, **dadurch gekennzeichnet,** daß der Damm aus gehärtetem Harz eine JIS-A-Härte von 40 bis 95 und die Vergußmasse aus gehärtetem Harz eine JIS-A-Härte von 1 bis 39 aufweist.

2. Harz-vergossene Vorrichtung nach Anspruch 1, bei der der Damm aus gehärtetem Harz und die Vergußmasse aus gehärtetem Harz einen Zusatz aus einer durch Reaktion härtenden Zusammensetzung enthalten.

## Revendications

1. Un dispositif à semi-conducteur enrobé de résine, dans lequel un barrage en résine durcie est formé dans la zone des fils de connexion qui connectent électriquement un élément à semi-conducteur à la surface d'une plaquette de circuits imprimés et l'élément à semi-conducteur est monté à l'intérieur du barrage en résine durcie et est recouvert d'un agent d'étanchéité en résine durcie, le barrage en résine durcie ayant une dureté supérieure à celle de l'agent d'étanchéité en résine durcie, caractérisé en ce que le barrage en résine durcie a une dureté JIS A de 40 à 95 et l'agent d'étanchéité en résine durcie a une dureté JIS A de 1 à 39.

2. Un dispositif enrobé de résine selon la revendication 1, dans lequel le barrage en résine durcie et l'agent d'étanchéité en résine durcie comprennent une composition durcissable par réaction d'addition.
